# EUROPÄISCHE PATENTANMELDUNG

(11) **EP 3 562 283 A1**
(43) Veröffentlichungstag der Anmeldung: **30.10.2019**
(21) Anmeldenummer: 18169236.9
(22) Anmeldetag: 25.04.2018
(51) Int. Cl.: H05K 7/14, G06F 1/18

(54) **MODULARE BACKPLANEANORDNUNG**

(71) Anmelder: Siemens Aktiengesellschaft, 80333 München (DE)
(72) Erfinder: BEIER, Axel, 16552 Schildow (DE); BURGER, Josef, 92546 Schmidgaden (DE); LUTZ, Christoph, 91054 Erlangen (DE); PÖHLER, Dirk, 08056 Zwickau (DE); SCHIFFEL, Andre, 09474 Crottendorf (DE); SEIDL, Joachim, 92237 Sulzbach-Rosenberg (DE); SERTL, Daniel, 95506 Kastl (DE); STEINDL, Dieter, 92284 Poppenricht (DE); WILKE, Klaus, 12527 Berlin (DE)

(57) **Zusammenfassung**

Die Erfindung betrifft einen Backplanemodulsatz, eine Backplaneanordnung (10) und einen Schaltschrank (30) zum elektrischen Verbinden elektrischer Bauelemente (14). Der Backplanemodulsatz umfasst mehrere miteinander verbindbare Backplanes (1 bis 7).

## Beschreibung

Die Erfindung betrifft einen Backplanemodulsatz zum elektrischen Verbinden elektrischer Bauelemente, eine Backplaneanordnung und einen Schaltschrank.

Unter einer Backplane wird hier ein Träger für elektrische Bauelemente verstanden, der elektrische Leitungen zum elektrischen Verbinden der elektrischen Bauelemente aufweist. Derartige elektrische Bauelemente sind beispielsweise Niederspannungsschaltgeräte wie Schütze, Motorschutzschalter, Motorstarter, Sanftstarter oder Relais, oder Steuerungseinheiten oder Eingabe-/Ausgabeeinheiten. In einem Schaltschrank werden elektrische Bauelemente einer technischen Vorrichtung oder Anlage angeordnet. In herkömmlichen Schaltschränken werden elektrische Bauelemente in der Regel durch Kabel elektrisch miteinander verbunden. Bei einer Vielzahl elektrischer Bauelemente entsteht dabei ein hoher Verkabelungsaufwand.

DE 10 2016 002 052 A1 offenbart einen Schaltschrank und ein Verfahren zu dessen Herstellung. Der Schaltschrank weist zumindest eine Schalttafel mit einer Grundplatte auf, auf der elektrische Schaltelemente angeordnet und miteinander elektrisch verbunden sind. Die zumindest eine Grundplatte und/oder zumindest eines der Schaltelemente wird mittels eines 3D-Druckers in einem 3D-Druckverfahren hergestellt.

Der Erfindung liegt die Aufgabe zugrunde, eine insbesondere hinsichtlich ihrer funktionellen und räumlichen Anpassbarkeit verbesserte Backplaneanordnung, insbesondere für einen Schaltschrank, ein Verfahren zu deren Herstellung und einen verbesserten Schaltschrank anzugeben.

Die Aufgabe wird erfindungsgemäß durch einen Backplanemodulsatz mit den Merkmalen des Anspruchs 1, ein Verfahren mit den Merkmalen des Anspruchs 12, eine Backplaneanordnung mit den Merkmalen des Anspruchs 14 und einen Schaltschrank mit den Merkmalen des Anspruchs 15 gelöst.

Vorteilhafte Ausgestaltungen der Erfindung sind Gegenstand der Unteransprüche.

Ein erfindungsgemäßer Backplanemodulsatz zum elektrischen Verbinden elektrischer Bauelemente umfasst mehrere miteinander verbindbare Backplanes.

Eine Ausgestaltung der Erfindung sieht vor, dass wenigstens zwei Backplanes voneinander verschiedene elektrische Leitungen und/oder elektrische Bauelemente aufweisen.

Die Erfindung ermöglicht es, Backplaneanordnungen modular aus mehreren, insbesondere aus voneinander verschiedenen Backplanes eines Backplanemodulsatzes zusammenzusetzen. Dadurch kann eine Backplaneanordnung flexibel kunden- und anwendungsspezifischen Anforderungen angepasst werden. Außerdem kann eine Backplaneanordnung erforderlichenfalls in einfacher Weise erweitert oder geändert werden, indem eine oder mehrere Backplanes hinzugefügt und/oder durch eine oder mehrere andere Backplanes ersetzt werden. Ferner braucht in einem Fehlerfall nicht unbedingt die gesamte Backplaneanordnung ausgetauscht werden, sondern es genügt unter Umständen, eine oder mehrere defekte Backplanes auszutauschen.

Eine weitere Ausgestaltung der Erfindung sieht vor, dass wenigstens eine Backplane mit mehreren anderen Backplanes verbindbar ist. Diese Ausgestaltung der Erfindung erhöht vorteilhaft die Gestaltungsmöglichkeiten von Backplaneanordnungen gegenüber dem Fall, dass jede Backplane des Backplanemodulsatzes mit nur einer anderen Backplane verbindbar ist.

Weitere Ausgestaltungen der Erfindung sehen vor, dass wenigstens zwei Backplanes derart miteinander verbindbar sind, dass die beiden miteinander verbundenen Backplanes parallel zueinander angeordnet sind, und/oder dass wenigstens zwei Backplanes derart miteinander verbindbar sind, dass die beiden miteinander verbundenen Backplanes in einem von Null Grad verschiedenen Winkel, insbesondere orthogonal zueinander angeordnet sind. Dabei ist der Winkel zwischen zwei Backplanes als ein Winkel zwischen den Normalenvektoren von vorder- oder rückseitigen Oberflächen der beiden Backplanes definiert. Diese Ausgestaltungen der Erfindung ermöglichen, Backplanes des Backplanemodulsatzes zu zwei- und/oder dreidimensionalen Backplaneanordnungen zusammenzusetzen. Dadurch kann eine Backplaneanordnung insbesondere einem in einem Schaltschrank verfügbaren Bauraum flexibel angepasst werden. Eine Anordnung von Backplanes in einem von Null Grad verschiedenen Winkel ermöglicht außerdem eine besonders platzsparende Nutzung des verfügbaren Bauraums durch einen dreidimensionalen Aufbau der Backplaneanordnung.

Eine weitere Ausgestaltung der Erfindung sieht vor, dass wenigstens zwei Backplanes miteinander elektrisch verbindbare Schnittstellen aufweisen. Beispielsweise bilden wenigstens zwei miteinander elektrisch verbindbare Schnittstellen eine Steckerverbindung, Kabelverbindung, Folienleiterverbindung, Schraubverbindung, Federzugverbindung, Lötverbindung oder Schweißverbindung. Ferner können wenigstens zwei Backplanes Schnittstellen aufweisen, die durch das Verbinden der beiden Backplanes miteinander elektrisch verbunden werden, und/oder wenigstens zwei Backplanes können Schnittstellen aufweisen, die unabhängig von dem Verbinden der beiden Backplanes miteinander elektrisch verbindbar sind. Elektrisch verbindbare Schnittstellen von Backplanes ermöglichen, die elektrischen Leitungen und elektrischen Bauelemente der Backplanes elektrisch zu verbinden. Schnittstellen, die durch das Verbinden der beiden Backplanes miteinander elektrisch verbunden werden, erleichtern die Montage einer Backplaneanordnung. Schnittstellen, die unabhängig von dem Verbinden der beiden Backplanes miteinander elektrisch verbindbar sind, beispielsweise Kabelverbindungen oder Folienleiterverbindungen, haben dagegen den Vorteil, dass die durch sie realisierten elektrischen Verbindungen unterbrechbar sind, ohne die Backplanes voneinander zu lösen.

Eine weitere Ausgestaltung der Erfindung sieht vor, dass wenigstens eine Backplane eine Sendeeinheit zum Senden und/oder eine Empfangseinheit zum Empfangen elektromagnetischer Strahlung zur drahtlosen Kommunikation und/oder Energieversorgung aufweist. Insbesondere kann wenigstens eine Backplane eine Sendeeinheit zum Senden und/oder eine Empfangseinheit zum Empfangen von Funkwellen, oder/und eine Sendeeinheit zum Senden und/oder eine Empfangseinheit zum Empfangen von Licht aufweisen. Diese Ausgestaltung ermöglicht insbesondere, dass Backplanes drahtlos miteinander kommunizieren und/oder drahtlos mit Energie versorgt werden.

Eine weitere Ausgestaltung der Erfindung sieht vor, dass eine der Backplanes dazu ausgebildet ist, wenigstens eine Grundfunktion für einen Hauptstromkreis und/oder einen Steuerstromkreis, insbesondere eine Stromversorgung und/oder eine Spannungsversorgung und/oder eine Kommunikation zwischen elektrischen Bauelementen, bereitzustellen. Diese Ausgestaltung der Erfindung berücksichtigt, dass beispielsweise in Schaltschränken bestimmte Grundfunktionen nahezu immer erforderlich sind. Derartige Grundfunktionen sind beispielsweise neben einer Strom- und/oder Spannungsversorgung eine Kommunikation mit einer übergeordneten Kommunikationseinheit und/oder zwischen elektrischen Bauelementen, zentrale Erfassungsmodule für Strom, Spannung und/oder Leistung und zentrale Steuer- und/oder Schalteinheiten zum Zu- und Abschalten von Modulen. Deshalb ist es vorteilhaft, derartige Grundfunktionen auf einer Backplane des Backplanemodulsatzes bereitzustellen. Auf den weiteren Backplanes des Backplanemodulsatzes werden dann vorzugsweise anwendungsspezifische Spezialfunktionen bereitgestellt. Auf diese Weise kann eine Backplaneanordnung einer bestimmten Anwendung durch eine anwendungsspezifische Erweiterung der die Grundfunktionen bereitstellenden Backplane um weitere Backplanes angepasst werden. Insbesondere kann eine Backplane als eine Grundfunktion eine Masterkommunikationseinheit aufweisen, und die anderen Backplanes können jeweils eine dazu korrespondierende Slavekommunikationseinheit aufweisen.

Bei dem erfindungsgemäßen Verfahren zur Herstellung eines erfindungsgemäßen Backplanemodulsatzes wird wenigstens eine Backplane wenigstens teilweise mit einem additiven Fertigungsverfahren, beispielsweise mit einem 3D-Druck, gefertigt.

Unter einem 3D-Druck wird ein Verfahren verstanden, bei dem ein dreidimensionales Objekt durch computergesteuertes schichtweises Auftragen von Material hergestellt wird.

Das erfindungsgemäße Verfahren zielt insbesondere darauf, Backplanes, die anwendungsspezifische Spezialfunktionen bereitstellen, additiv zu fertigen. Derartige Backplanes werden typischerweise als Einzelstücke oder in einer geringen Stückzahl benötigt und werden daher zweckmäßigerweise wenigstens teilweise mit einem additiven Fertigungsverfahren wie mit einem 3D-Druck gefertigt.

Eine erfindungsgemäße Backplaneanordnung zum elektrischen Verbinden elektrischer Bauelemente ist aus miteinander verbundenen Backplanes eines erfindungsgemäßen Backplanemodulsatzes zusammengesetzt. Ein erfindungsgemäßer Schaltschrank weist eine erfindungsgemäße Backplaneanordnung auf. Die Verwendung einer erfindungsgemäßen Backplaneanordung in einem Schaltschrank reduziert vorteilhaft den Aufwand und die Kosten zum elektrischen Verbinden elektrischer Bauelemente in dem Schaltschrank gegenüber dem herkömmlichen Verbinden elektrischer Bauelemente durch Kabel. Weitere Vorteile einer erfindungsgemäßen Backplaneanordnung und eines erfindungsgemäßen Schaltschranks ergeben sich aus den oben genannten Vorteilen eines erfindungsgemäßen Backplanemodulsatzes.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine Draufsicht auf eine Backplane eines Backplanemodulsatzes,
- FIG 2: eine Draufsicht auf ein erstes Ausführungsbeispiel einer Backplaneanordnung,
- FIG 3: eine perspektivische Darstellung eines zweiten Ausführungsbeispiels einer Backplaneanordnung,
- FIG 4: einen Schaltschrank mit einem dritten Ausführungsbeispiel einer Backplaneanordnung.

Einander entsprechende Teile sind in den Figuren mit denselben Bezugszeichen versehen.

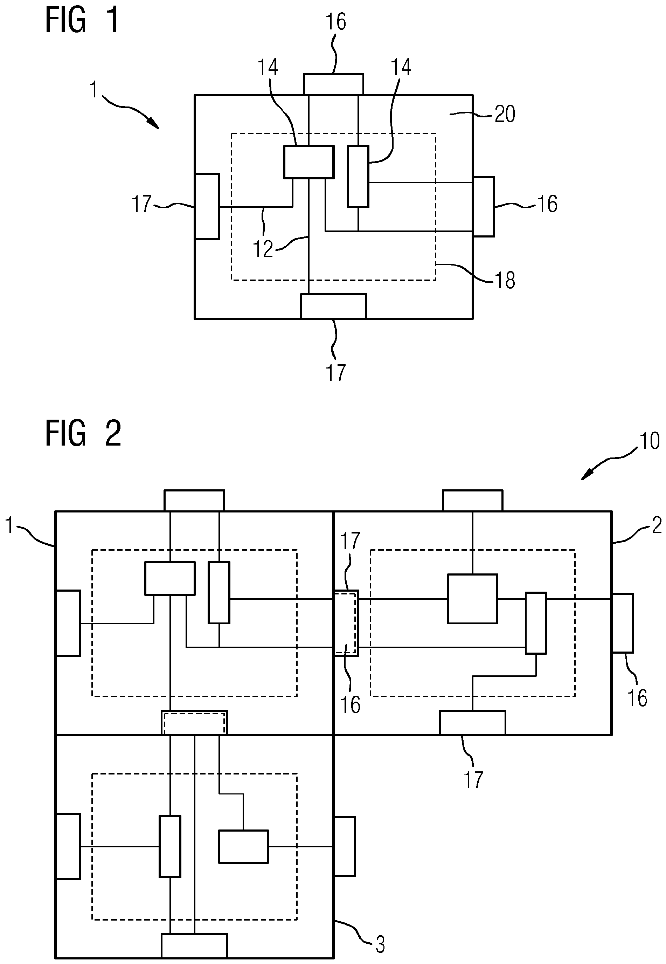

Figur 1 zeigt eine Draufsicht auf eine Backplane 1 eines Backplanemodulsatzes. Die Backplane 1 weist elektrische Leitungen 12, elektrische Bauelemente 14 und Schnittstellen 16, 17 auf.

Die elektrischen Bauelemente 14 sind in einem Mittelbereich 18 der Backplane 1 angeordnet. Die Schnittstellen 16, 17 sind seitlich in einem um den Mittelbereich 18 herum verlaufenden Randbereich 20 der Backplane 1 angeordnet. Die Schnittstellen 16, 17 sind dazu ausgebildet, die Backplane 1 mechanisch und elektrisch mit anderen Backplanes 2, 3 (siehe Figur 2) des Backplanemodulsatzes zu verbinden. Beispielsweise weisen erste Schnittstellen 16 jeweils einen Einbaustecker auf und zweite Schnittstellen 17 weisen jeweils eine zu einem Einbaustecker einer ersten Schnittstelle 16 korrespondierende Buchse auf. Der Randbereich 20 weist eine rechteckige Kontur auf. An jeder Seite der Kontur ist eine Schnittstelle 16, 17 angeordnet, wobei sich jeweils eine erste Schnittstelle 16 und eine zweite Schnittstelle 17 gegenüberliegen. Die elektrischen Leitungen 12 verbinden elektrische Bauelemente 14 und Schnittstellen 16, 17.

Figur 2 zeigt eine Draufsicht auf ein erstes Ausführungsbeispiel einer Backplaneanordnung 10. Die Backplaneanordnung 10 weist drei Backplanes 1 bis 3 eines Backplanemodulsatzes auf, die parallel zueinander angeordnet sind. Die Backplanes 1 bis 3 weisen wie in Figur 1 ausgeführte und angeordnete Schnittstellen 16, 17 auf, die jeweils seitlich an einer Backplane 1 bis 3 angeordnet sind. Eine erste Backplane 1 ist mit einer zweiten Backplane 2 und mit der dritten Backplane 3 verbunden, wobei eine erste Schnittstelle 16 der ersten Backplane 1 mit einer zweiten Schnittstelle 17 der zweiten Backplane 2 verbunden ist und eine zweite Schnittstelle 17 der ersten Backplane 1 mit einer ersten Schnittstelle 16 der dritten Backplane 3 verbunden ist.

Die Backplanes 1 bis 3 unterscheiden sich voneinander hinsichtlich ihrer elektrischen Leitungen 12 und elektrischen Bauelemente 14. Beispielsweise weist eine erste Backplane 1 elektrische Leitungen 12 und elektrische Bauelemente 14 auf, die Standardfunktionen eines Schaltschranks 30 erfüllen, beispielsweise wenigstens eine Grundfunktion, insbesondere eine Stromversorgung und/oder eine Spannungsversorgung und/oder eine Kommunikation zwischen elektrischen Bauelementen 14, für einen Hauptstromkreis und/oder einen Steuerstromkreis. Die erste Backplane 1 kann daher in einer großen Stückzahl hergestellt werden. Die anderen Backplanes 2, 3 weisen beispielsweise elektrische Leitungen 12 und elektrische Bauelemente 14 auf, die anwendungsspezifische Spezialfunktionen erfüllen. Diese Backplanes 2, 3 werden daher als Einzelstücke oder in einer geringen Stückzahl hergestellt und vorzugsweise wenigstens teilweise mit einem additiven Fertigungsverfahren, beispielsweise mit einem 3D-Druck, gefertigt. Es kann zudem vorgesehen sein, auch die erste Backplane 1 wenigstens teilweise mit einem additiven Fertigungsverfahren, beispielsweise mit einem 3D-Druck, herzustellen.

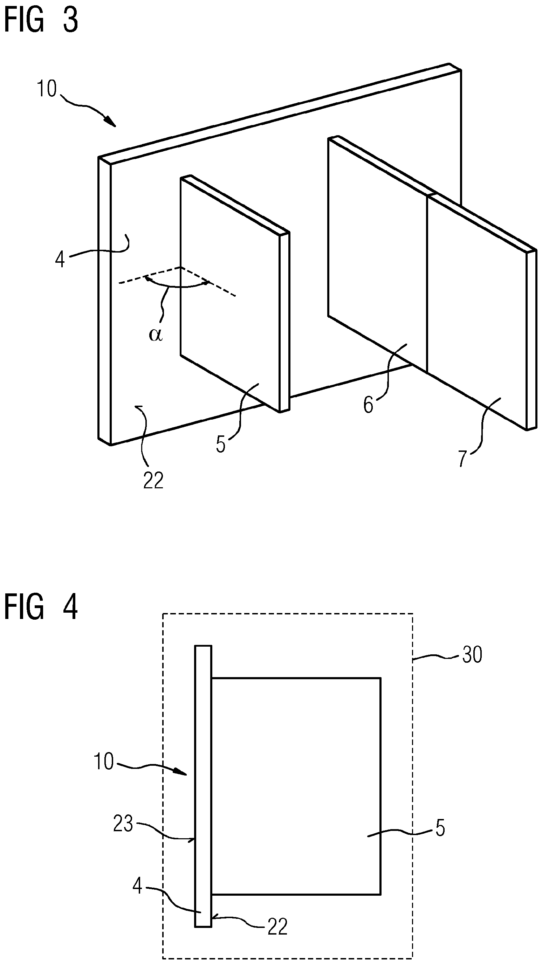

Figur 3 zeigt ein Ausführungsbeispiel einer Backplaneanordnung 10, die aus Backplanes 4 bis 7 zusammengesetzt ist, die nicht nur parallel, sondern auch auch in einem von Null Grad verschiedenen Winkel α, insbesondere orthogonal, das heißt in einem Winkel α von 90 Grad, zueinander angeordnet werden können. Dazu weist wenigstens eine Backplane 4 Schnittstellen 16, 17 auf, die auf einer Vorderseite 22 der Backplane 4, beispielsweise in einem Mittelbereich 18 (siehe Figur 1) der Backplane 4, angeordnet sind. In dem in Figur 3 gezeigten Ausführungsbeispiel sind an einer ersten Backplane 4 eine zweite Backplane 5 und eine dritte Backplane 6 in einem von Null Grad verschiedenen Winkel α zu der ersten Backplane 4 angeordnet, und an der dritten Backplane 6 ist eine vierte Backplane 7 parallel zu der dritten Backplane 6 angeordnet.

Insbesondere kann vorgesehen sein, dass jede Backplane 4 bis 7 eines Backplanemodulsatzes sowohl wie in Figur 1 seitlich an der Backplane 4 bis 7 angeordnete Schnittstellen 16, 17 als auch auf der Vorderseite 22 und der Rückseite 23 der Backplane 4 angeordnete Schnittstellen 16, 17 aufweist.

Durch in einem von Null Grad verschiedenen Winkel α zueinander anordenbare Backplanes 4 bis 7 kann aus den Backplanes 4 bis 7 eine dreidimensionale Backplaneanordnung 10 zusammengesetzt werden und damit insbesondere der Bauraum eines Schaltschranks 30 besser genutzt werden.

Figur 4 zeigt schematisch einen aufgebrochen dargestellten Schaltschrank 30 mit einer Backplaneanordnung 10, die zwei in einem von Null Grad verschiedenen Winkel α zueinander angeordnete Backplanes 4, 5 aufweist.

Die anhand der Figuren 1 bis 4 beschriebenen Ausführungsbeispiele von Backplaneanordnungen 10 können auf verschiedene Weisen modifiziert werden. Beispielsweise können alternativ oder zusätzlich zu Schnittstellen 16, 17 mit elektrischen Steckerverbindungen andere oder weitere miteinander elektrisch verbindbare Schnittstellen 16, 17 verschiedener Backplanes 1 bis 7 vorgesehen sein, beispielsweise Schraubverbindungen, Federzugverbindungen, Lötverbindungen, Schweißverbindungen oder Kontaktbrückenverbindungen wie Kabel- oder Folienleiterverbindungen. Ferner kann vorgesehen sein, dass auf einzelnen Backplanes 1 bis 7 eines Backplanemodulsatzes jeweils elektrische Bauelemente 14 angeordnet sind, die einem gemeinsamen Stromkreis, beispielsweise einem Haupt- oder Hilfsstromkreis, angehören und/oder einem bestimmten Leistungsbereich zugeordnet sind und/oder eine ähnliche Funktion, beispielsweise eine Sensor-, Auswerte-, Schalt- oder Kommunikationsfunktion, haben und/oder derselben Baugruppe einer mit der Backplaneanordnung 10 verbundenen Vorrichtung oder Anlage zugeordnet sind.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Backplanemodulsatz zum elektrischen Verbinden elektrischer Bauelemente (14), der Backplanemodulsatz umfassend mehrere miteinander verbindbare Backplanes (1 bis 7).

2. Backplanemodulsatz nach Anspruch 1, wobei wenigstens zwei Backplanes (1 bis 7) voneinander verschiedene elektrische Leitungen (12) und/oder elektrische Bauelemente (14) aufweisen.

3. Backplanemodulsatz nach Anspruch 1 oder 2, wobei wenigstens eine Backplane (1 bis 7) mit mehreren anderen Backplanes (1 bis 7) verbindbar ist.

4. Backplanemodulsatz nach einem der vorhergehenden Ansprüche, wobei wenigstens zwei Backplanes (1 bis 7) derart miteinander verbindbar sind, dass die beiden miteinander verbundenen Backplanes (1 bis 7) parallel zueinander angeordnet sind.

5. Backplanemodulsatz nach einem der vorhergehenden Ansprüche, wobei wenigstens zwei Backplanes (1 bis 7) derart miteinander verbindbar sind, dass die beiden miteinander verbundenen Backplanes (1 bis 7) in einem von Null Grad verschiedenen Winkel (α), insbesondere orthogonal zueinander angeordnet sind.

6. Backplanemodulsatz nach einem der vorhergehenden Ansprüche, wobei wenigstens zwei Backplanes (1 bis 7) miteinander elektrisch verbindbare Schnittstellen (16, 17) aufweisen.

7. Backplanemodulsatz nach Anspruch 6, wobei wenigstens zwei miteinander elektrisch verbindbare Schnittstellen (16, 17) eine Steckerverbindung oder Kabelverbindung oder Folienleiterverbindung oder Schraubverbindung oder Federzugverbindung oder Lötverbindung oder Schweißverbindung bilden.

8. Backplanemodulsatz nach Anspruch 6 oder 7, wobei wenigstens zwei Backplanes (1 bis 7) Schnittstellen (16, 17) aufweisen, die durch das Verbinden der beiden Backplanes (1 bis 7) miteinander elektrisch verbunden werden.

9. Backplanemodulsatz nach einem der Ansprüche 6 bis 8, wobei wenigstens zwei Backplanes (1 bis 7) Schnittstellen (16, 17) aufweisen, die unabhängig von dem Verbinden der beiden Backplanes (1 bis 7) miteinander elektrisch verbindbar sind.

10. Backplanemodulsatz nach einem der vorhergehenden Ansprüche, wobei wenigstens eine Backplane (1 bis 7) eine Sendeeinheit zum Senden und/oder eine Empfangseinheit zum Empfangen elektromagnetischer Strahlung zur drahtlosen Kommunikation und/oder Energieversorgung aufweist.

11. Backplanemodulsatz nach einem der vorhergehenden Ansprüche, wobei eine der Backplanes (1 bis 7) dazu ausgebildet ist, wenigstens eine Grundfunktion für einen Hauptstromkreis und/oder einen Steuerstromkreis, insbesondere eine Stromversorgung und/oder eine Spannungsversorgung und/oder eine Kommunikation zwischen elektrischen Bauelementen (14), bereitzustellen.

12. Verfahren zur Herstellung eines Backplanemodulsatzes gemäß einem der vorhergehenden Ansprüche, wobei wenigstens eine Backplane (1 bis 7) wenigstens teilweise mit einem additiven Fertigungsverfahren gefertigt wird.

13. Verfahren nach Anspruch 12, wobei wenigstens eine Backplane (1 bis 7) wenigstens teilweise mit einem 3D-Druck gefertigt wird.

14. Backplaneanordnung (10) zum elektrischen Verbinden elektrischer Bauelemente (14), wobei die Backplaneanordnung (10) aus miteinander verbundenen Backplanes (1 bis 7) eines Backplanemodulsatzes nach einem der Ansprüche 1 bis 11 zusammengesetzt ist.

15. Schaltschrank (30) mit einer gemäß Anspruch 14 ausgebildeten Backplaneanordnung (10).
